# EUROPÄISCHE PATENTSCHRIFT

(11) **EP 3 335 013 B1**
(45) Veröffentlichungstag und Bekanntmachung des Hinweises auf die Patenterteilung: **01.04.2020**
(21) Anmeldenummer: 16753607.7
(22) Anmeldetag: 29.07.2016
(51) Int. Cl.: G01D 5/243, G01D 5/20

(54) **VORRICHTUNG ZUM MESSEN EINER MESSGRÖSSE**
DEVICE FOR MEASURING A MEASUREMENT VARIABLE
DISPOSITIF DE MESURE D'UNE GRANDEUR DE MESURE

(30) Priorität: 11.08.2015 DE 102015215330; 11.08.2015 DE 102015215331; 12.08.2015 DE 102015215352
(43) Veröffentlichungstag der Anmeldung: 20.06.2018
(73) Patentinhaber: Continental Teves AG & Co. OHG, 60488 Frankfurt am Main (DE)
(72) Erfinder: ACKER, Heinrich, 65824 Schwalbach (DE)
(86) Internationale Anmeldenummer: PCT/EP2016/068157
(87) Internationale Veröffentlichungsnummer: WO 2017/025354

(56) Entgegenhaltungen:
- EP-A2- 1 744 184
- DE-A1- 10 128 010
- US-A- 5 952 822
- US-A1- 2003 107 377

## Beschreibung

Die Erfindung betrifft eine Vorrichtung zum Messen einer Messgröße. Insbesondere kann es sich dabei um einen induktiven Sensor handeln.

Induktive Sensoren basieren typischerweise auf einer Änderung eines oder mehrerer Kennwerte eines Systems eines oder mehrerer induktiver Bauelemente durch eine Messgröße. Derartige induktive Bauelemente können beispielsweise Spule, Wicklung oder Induktivität genannt werden.

Als Kennwerte kommen insbesondere in Frage:
- Selbstinduktivität L, auch kurz Induktivität genannt,
- Verlustwiderstand R, der sich aus einem ohmschen Widerstand der Wicklung und anderen Verlustbeiträgen zusammensetzt,
- komplexe Impedanz Z = jωL + R mit der imaginären Einheit j und der Kreisfrequenz ω,
- Verlustwinkel δ = arctan(Re{Z}/Im{Z}),
- sowie, insbesondere im Falle der magnetischen Kopplung zwischen mehreren Bauelementen, Gegeninduktivität M. Die Gegeninduktivität M kann u.a. als induzierte Spannung in einem Leiter als Reaktion auf einen bekannten Strom in einem anderen Leiter indirekt gemessen werden.

Messgrößen, die die Änderung der Kennwerte bewirken, können unter anderem Position bzw. Länge, Winkel, Kraft, Druck oder Drehmoment sein. Als Anwendung kann beispielhaft ein Positionssensor für das Bremspedal eines Automobils genannt werden.

Für induktive Sensoren existieren im Stand der Technik insbesondere zwei schaltungstechnische Hauptansätze, um eine elektrische Messung der Kennwerte vorzunehmen:
Zum einen ist dies ein resonantes System: Der induktive Sensor mit seinem variablen Kennwert, meist der Induktivität L, ist Teil des frequenzbestimmenden Netzwerks eines Oszillators. Der Oszillator schwingt stets mit seiner Eigenfrequenz, deren wichtigster Einflussfaktor L ist. Die Messung von L ist somit auf eine Frequenzmessung zurückgeführt, die z.B. durch Zählen der Perioden oder Nulldurchgänge der Oszillatorschwingung leicht vorgenommen werden kann.

Zum anderen ist dies ein Lock-in-Verstärker (auch phasenempfindlicher Gleichrichter, Synchrondemodulator oder Trägerfrequenzverstärker) : Der induktive Sensor erhält einen Stimulus mit einer festen Frequenz (Strom oder Spannung). Eine Signalverarbeitungsschaltung misst die jeweils andere elektrische Größe an der Impedanz (Spannung oder Strom). Die Signalverarbeitung entspricht einer schmalbandigen Filterung dieser Größe um die Frequenz des Stimulus mit anschließender Bestimmung der komplexen Amplitude und Quotientenbildung mit dem Stimulus zur Bestimmung des Kennwerts. Diese Funktionen können wahlweise mit analoger Elektronik oder weitgehend mit den Mitteln digitaler Signalverarbeitung und Software realisiert werden.

Beide Ansätze weisen unterschiedliche Nachteile auf.

Das resonante System weist Einschränkungen beim Entwurf des induktiven Systems auf, weil pro Oszillator nur eine Schwingung möglich ist. Mehrere Signale lassen sich nur mit mehreren unabhängigen Oszillatoren und induktiven Systemen gewinnen, wodurch sich der Aufwand für Sensoren mit ratiometrischer oder differentieller Messung deutlich erhöht. Darüber hinaus weist das induktive System stets Frequenzabhängigkeiten auf, d.h. es kann nur für eine Frequenz optimal ausgelegt werden; der Frequenzbereich des Oszillators ist immer ein Kompromiss. Über die Veränderung der Schwingungsfrequenz können Querempfindlichkeiten das Messergebnis verfälschen, weil beispielsweise die Induktivität L zusätzlich zur Empfindlichkeit auf die Messgröße von einer weiteren frequenzabhängigen Größe beeinflusst wird. Schließlich muss die Differenz des maximalen und des minimalen Zählergebnisses der Frequenzmessung einen Mindestwert überschreiten, damit die jeweiligen Anforderungen bezüglich Messgenauigkeit und -auflösung erreicht werden. Dafür ist je nach Frequenz eine minimale Messzeit erforderlich, die unter Umständen gar nicht zur Verfügung steht.

Der Lock-in-Verstärker hingegen arbeitet mit einer konstanten Frequenz, erfordert aber auch einen Stimulus mit dieser Frequenz. Die Frequenz dieser erzwungenen Schwingungen ist frei wählbar, aufgrund der Frequenzabhängigkeit des induktiven Systems stellt dies aber einen Widerspruch zum Betrieb in Resonanz, d.h. mit Schwingungen auf der Eigenfrequenz dar. Daher können die folgenden Vorteile der Resonanz nicht genutzt werden: Das induktive System, als Resonator betrieben, stellt bereits einen Filter dar, indem es in seiner Eigenfrequenz eine besonders hohe Amplitude erreichen kann, die die Messung erleichtert. Störungen, deren Frequenz deutlich von dieser Frequenz abweicht, werden durch die Filterwirkung unterdrückt. Darüber hinaus ist in Resonanz der Leistungsbedarf des induktiven Systems zur Aufrechterhaltung der Schwingung am geringsten, wenn alle anderen Parameter gleich bleiben. Bei gegebener Leistung des Stimulus ist somit eine besonders hohe Amplitude möglich. Diese beiden Vorteile stellen natürlich denselben Sachverhalt dar, einmal aus Sicht der Messung und einmal aus Sicht des Stimulus.

Das Dokument US 5 952 822 A zeigt einen in Resonanz betreibbaren induktiven Näherungssensor.

Es ist deshalb eine Aufgabe der Erfindung, eine im Vergleich zum Stand der Technik alternative, insbesondere verbesserte Vorrichtung zum Messen einer Messgröße zur Verfügung stellen. Dies wird erfindungsgemäß durch eine Vorrichtung nach Anspruch 1 erreicht. Vorteilhafte Ausgestaltungen können beispielsweise den abhängigen Ansprüchen entnommen werden. Der Inhalt der Ansprüche wird durch ausdrückliche Inbezugnahme zum Inhalt der Beschreibung gemacht.

Die Erfindung betrifft eine Vorrichtung zum Messen einer Messgröße. Die Vorrichtung weist eine erste Induktivität auf. Sie weist eine Messinduktivität auf, welche zum Abfühlen der Messgröße ausgebildet ist und welche mit der ersten Induktivität gekoppelt ist. Außerdem weist sie eine Kapazität auf, welche mit der ersten Induktivität zu einem Parallelschwingkreis verschaltet ist.

Die Vorrichtung weist des Weiteren eine elektronische Steuerungseinheit auf. Die elektronische Steuerungseinheit ist direkt mit dem Parallelschwingkreis verbunden und ist dazu konfiguriert, den Parallelschwingkreis mit einer Anregungsfrequenz oszillierend anzuregen, welche aus einem Takt der elektronischen Steuerungseinheit abgeleitet ist. Außerdem ist die elektronische Steuerungseinheit direkt mit der Messinduktivität verbunden und ist dazu konfiguriert, einen die Messgröße anzeigenden Wert an der Messinduktivität zu messen.

Mittels der erfindungsgemäßen Vorrichtung kann die Messinduktivität lediglich unter Verwendung einer elektronischen Steuerungseinheit in einem Schwingkreis vermessen werden. Dies spart Energie, da der Schwingkreis von sich aus schwingt und im Regelfall nur verlorene Energie nachgeführt wird. Es findet also eine erzwungene Schwingung statt. Diese erlaubt eine Nutzung der Vorteile der Resonanz und ist von den oben angesprochenen Beschränkungen eines resonanten Systems frei. Die Verwendung einer elektronischen Steuerungseinheit zur Implementierung der Funktionen spart Kosten und vereinfacht das System.

Die Anregung des Schwingkreises kann auch als Stimulus bezeichnet werden. Die Anregungsfrequenz kann auch als Stimulusfrequenz bezeichnet werden. Die Ableitung von einem Takt kann insbesondere durch die Ableitung von einem internen, jedoch auch von einem externen Takt erfolgen. Dies bedeutet insbesondere, dass die Anregungsfrequenz unabhängig ist von einer Resonanzfrequenz des Parallelschwingkreises.

Insbesondere kann die Vorrichtung so aufgebaut sein, dass sie keine zur elektronischen Steuerungseinheit externen Verstärker aufweist. Dies spart ebenfalls Kosten. Typischerweise schließt das Vorsehen einer direkten Verbindung einen jeweiligen Verstärker zwischen elektronischer Steuerungseinheit und Komponente wie Induktivität oder Kapazität bzw. Schwingkreis aus. Ein jeweiliger Verstärker kann insbesondere in der elektronischen Steuerungseinheit integriert sein.

Die Wirkung eines Schwingkreises in der Nähe der Resonanzfrequenz bewirkt auch ohne resonante Schwingung vier erfindungsgemäße Vorteile:
1. Die Spannungsspitzen und damit die Gefahr für die Portpins verschwinden.
2. Der Strom durch die Induktivitäten steigt deutlich an, daher wird mehr magnetischer Fluss im induktiven System erzeugt, gleichbedeutend mit einem stärkeren Signal.
3. Der Strom durch die Induktivitäten wird nahezu sinusförmig, was unter Gesichtspunkten der elektromagnetischen Verträglichkeit günstig und für die nachgeschaltete Signalverarbeitung vorteilhaft ist.
4. Der Strom in den Zuleitungen der Schwingkreise sinkt, weil die Impedanz des Schwingkreises in der Nähe der Resonanz besonders hoch ist. Dadurch wird ermöglicht, den Stimulus mit wenigen Portpins bzw. Ausgangsstufen geringer Strombelastbarkeit zu erzeugen.

Zum Schutz der Portpins vor Spannungen außerhalb des zulässigen Bereichs ist der komplementäre Stimulus vorteilhaft, weil dieser eine Schwingung um den Mittelwert der Versorgungsspannung bewirkt. Dabei ist eine Amplitude von ebenfalls der halben Versorgungsspannung möglich bzw. zulässig; je nach Spezifikation des Mikrokontrollers auch darüber hinaus, beispielsweise bis zur halben Versorgungsspannung + 0,5 V. Die Spannungen an den Portpins sind wegen des Innenwiderstandes der Ausgangsstufen typischerweise keine Rechteckspannungen mehr. Ein Stimulus, der einseitig mit Portpins gegen Bezugspotential oder Versorgungsspannung arbeitet, bietet typischerweise keine vergleichbaren Möglichkeiten, denn jeder Stimulus (Wechselspannung), der zu diesen Spannungen addiert wird, liegt bereits bei geringen Amplituden außerhalb des zulässigen Bereichs.

Unter einer elektronischen Steuerungseinheit können beispielsweise ein Mikroprozessor oder ein Mikrokontroller verstanden werden. Unter einem Mikrokontroller ist dabei insbesondere ein Bauelement zu verstehen, das neben den Funktionen eines Mikroprozessors auch Schreib-Lese-Speicher (RAM), mindestens eine Art Festwertspeicher (ROM, EPROM, EEPROM, Flash, o.ä.), Analog-Digital-Konverter (ADC) und/oder Timer- und Portbausteine auf einem Chip integriert enthält. Ein solches Bauelement benötigt typischerweise zum Betrieb keinen externen Speicher und kann ohne Außenbeschaltung ein Programm ausführen sowie Messungen mit dem ADC vornehmen und digitale Signale über Portpins ausgeben, die durch Software oder durch die Timerbausteine bestimmt sind. Dazu erhält der Mikrokontroller typischerweise lediglich eine Spannungs- und Taktversorgung sowie einen Reset-Impuls beim Einschalten. Bei modernen Bauelementen können ein Taktoszillator und eine Reset-Logik auch integriert sein, so dass typischerweise nur die Versorgungsspannung von außen zugeführt wird.

Es kann sich jedoch bei der elektronischen Steuerungseinheit beispielsweise auch um eine Anordnung aus einem Mikroprozessor mit Außenbeschaltung wie Speicher und Taktversorgung, um einen anwendungsspezifischen integrierten Schaltkreis (ASIC), um eine speicherprogrammierbare Steuerung (SPS) oder um einen integrierten Schaltkreis (IC) handeln.

Zum Messen wird typischerweise ein Analog-Digital-Konverter der elektronischen Steuerungseinheit bzw. des Mikrokontrollers verwendet. Bei den meisten Mikrokontrollern ist der ADC über einen Multiplexer mit einer Anzahl von Portpins verbunden, an denen die Spannung gemessen werden kann. Die Anzahl als Eingang benutzter Portpins und die Abfolge, in der die Eingänge zum ADC durchgeschaltet werden, sind typischerweise konfigurierbar. Die mit dem Multiplexer verbundenen Portpins stehen somit als Eingänge für die Durchführung mehrerer unabhängiger Messungen zur Verfügung.

Es wird davon ausgegangen, dass die Messergebnisse meist nicht nur in der elektronischen Steuerungseinheit bzw. im Mikrokontroller verbleiben sollen, sondern an andere Systeme weitergegeben werden, beispielsweise durch eine serielle Schnittstelle. Hierfür können geeignete Bauelemente vorhanden sein.

Es kann auch eine integrierte Schaltung (IC) als Mikrokontroller betrachtet oder definiert werden, die die oben genannten Schaltungsfunktionen enthält. Es ist dazu nicht notwendig, dass das IC auch vom Hersteller als Mikrokontroller vermarktet wird oder als Standardbaustein frei verkäuflich ist. In diesem Sinne gilt insbesondere ein ASIC ("Application Specific Integrated Circuit", insbesondere ein für eine Kundenapplikation entwickeltes IC), das alle technischen Kriterien erfüllt, als ein Mikrokontroller.

Als die Messgröße anzeigender Wert kommen insbesondere in Frage:
- Selbstinduktivität L, auch kurz Induktivität genannt,
- Verlustwiderstand R, der sich aus einem ohmschen Widerstand der Wicklung und anderen Verlustbeiträgen zusammensetzt,
- komplexe Impedanz Z = jωL + R mit der imaginären Einheit j und der Kreisfrequenz ω,
- Verlustwinkel δ = arctan(Re{Z}/Im{Z}),
- sowie, insbesondere im Falle einer magnetischen Kopplung zwischen mehreren Bauelementen, Gegeninduktivität M. Die Gegeninduktivität M kann u.a. als induzierte Spannung in einem Leiter als Reaktion auf einen bekannten Strom in einem anderen Leiter indirekt gemessen werden.

Aus dem die Messgröße anzeigenden Wert kann typischerweise auf die Messgröße geschlossen werden, beispielsweise kann die Messgröße berechnet oder in einer Tabelle nachgeschlagen werden.

Erfindungsgemäß ist vorgesehen, dass der Parallelschwingkreis an einem ersten Portpin und an einem zweiten Portpin der elektronischen Steuerungseinheit angeschlossen ist. Geschickter Weise wird dabei der zweite Portpin mit einem zum ersten Portpin invertierten Takt versorgt.

Hierdurch kann erreicht werden, dass eine Schwingung des Parallelschwingkreises nicht um ein Bezugspotential, insbesondere Masse, oder um die Versorgungspannung erfolgt, sondern um die halbe Versorgungsspannung oder zumindest um in etwa in halbe Versorgungsspannung. Dies vermeidet eine Gefährdung der elektronischen Steuerungseinheit bzw. der Portpins oder ihrer Beschaltung.

Die Anregungsfrequenz kann insbesondere durch Herunterteilen oder Übernahme eines Systemtakts am Portpin erreicht werden. Dies erlaubt die Bereitstellung eines mit der Anregungsfrequenz getakteten Signals am Portpin unter Verwendung gängiger Funktionalität einer Steuerungseinheit wie beispielsweise eines Mikrocontrollers.

Der Stimulus kann insbesondere von einem Systemtakt eines Mikrokontrollers oder einer anderen elektronischen Steuerungseinheit abgeleitet werden. Dazu kann ein Timer oder Zähler verwendet werden. Dieser teilt typischerweise den Takt in einem ganzzahligen Verhältnis auf die Frequenz des Stimulus herunter. In manchen Fällen ist auch eine direkte Verwendung des Systemtaktes möglich. Der geteilte Takt wird bevorzugt mit den Ausgangsstufen von zwei oder mehr Portpins verbunden, wobei ein Portpin oder eine Gruppe von Portpins mit dem Takt selbst angesteuert werden, ein zweiter Portpin oder eine zweite Gruppe von Portpins hingegen mit dem invertierten Takt. Je nach Architektur eines Mikrokontrollers kann es dabei notwendig sein, für jeden Portpin einen eigenen Timer zu verwenden, weil jeder Timer nur mit einem bestimmten Portpin verbunden werden kann, ohne dass eine Möglichkeit zur Verzweigung des Timersignals besteht. Dieser Umstand stellt meist kein Problem dar, weil moderne Mikrokontroller über viele Timer verfügen und meist nur wenige Portpins benötigt werden, minimal zwei.

Da die Auswahl der Frequenz des Stimulus durch Einstellung des Timers erfolgen kann, kann diese Frequenz im Betrieb des Systems durch Software optional verändert werden.

Gemäß einer Ausführung kann zwischen einer Anzahl der Portpins und einer Induktivität, also beispielsweise der ersten Induktivität oder der Messinduktivität, ein jeweiliger Widerstand, insbesondere ein Ohm'scher Widerstand, verschaltet sein. Auch dies sei noch unter einem direkten Anschluss verstanden. Mit dem Widerstand kann insbesondere ein Strom begrenzt werden, was eine Beschädigung aufgrund Überlastung vermeidet.

Der Parallelschwingkreis kann parallel zum ersten Portpin mit einer Anzahl weiterer erster Portpins verbunden sein, welche zum ersten Portpin synchron geschalten werden. Er kann auch parallel zum zweiten Portpin mit einer Anzahl weiterer zweiter Portpins verbunden ist, welche zum zweiten Portpin synchron geschalten werden. Damit können die jeweiligen maximalen Strombelastungen der Portpins addiert werden, so dass insgesamt ein höherer maximaler Strom erreicht werden kann als bei Verwendung nur eines Portpins.

Unter einer synchronen Schaltung ist dabei insbesondere zu verstehen, dass an den jeweiligen Portpins grundsätzlich das gleiche Potential anliegt, dieses also auch gleichzeitig umgeschaltet wird.

Die Spannungen an den Portpins dienen insbesondere als Stimulus. Es gibt hauptsächlich zwei Gründe, optional anstelle eines einzelnen Portpins, welches mit dem Takt versorgt wird, sowie eines einzelnen Portpins, welches mit dem invertierten Takt versorgt wird, jeweils eine Gruppe von Portpins zu verwenden. Zum einen kann eine Anzahl Portpins, die eine zu geringe Strombelastbarkeit aufweisen, durch Parallelschaltung einen entsprechend der Anzahl vielfachen Strom bereitstellen, wie bereits weiter oben erwähnt. So können induktive Systeme mit einem Stimulus versorgt werden, deren Impedanz andernfalls zu gering wäre. Zum anderen kann das induktive System mehrere mit Stimulus zu versorgende Induktivitäten vorsehen. In diesem Fall kann die Verwendung eines Timers pro Portpin optional auch ermöglichen, die einzelnen Induktivitäten mit Stimuli unterschiedlicher Frequenz oder Phasenlage zu versorgen.

Es sei deshalb erwähnt, dass auch das Anschließen weiterer Induktivitäten an weitere Portpins möglich ist.

Bevorzugt weisen Portpins, an welchen der Parallelschwingkreis angeschlossen ist, eine Push-Pull-Ausgangsstufe oder eine Tristate-Ausgangsstufe auf. Dies kann insbesondere bedeuten, dass je ein Schaltelement (Bipolar- oder MOS-Transistor) für eine niederohmige Verbindung zu den Spannungen der beiden Logikpegel vorhanden ist. Derartige Ausführungen haben sich für die vorliegende Anwendung als vorteilhaft erwiesen.

Gemäß einer bevorzugten Ausführung ist vorgesehen, dass sich die Anregungsfrequenz um maximal 25 %, bevorzugt maximal 20 %, besonders bevorzugt maximal 15 %, noch weiter bevorzugt maximal 10 % von einer Resonanzfrequenz des Parallelschwingkreises unterscheidet. Damit wird eine vorteilhafte Anregung erreicht. Ein Betrieb bei Resonanzfrequenz ist typischerweise nicht beabsichtigt, kann jedoch als Grenzfall normalerweise toleriert werden.

Die Schaltung des Stimulus, wie insbesondere auch die hierin beschriebene Messschaltung, skaliert gut und lässt sich ohne Änderung der Anforderungen an die elektronische Steuerungseinheit bzw. den Mikrokontroller mit Anregungsfrequenzen vom kHz-Bereich bis in den MHz-Bereich betreiben, z.B. bevorzugt von 5 kHz bis 5 MHz. Dazu werden typischerweise nur die Parameter des induktiven Systems und des Kondensators des Schwingkreises angepasst. Die Untergrenze von 5 kHz bewirkt insbesondere, dass die Induktivitäten ausreichend klein ausgeführt werden können und das System, an dem gemessen werden soll, möglichst wenig beeinflussen. Die Obergrenze bewirkt insbesondere, dass die parasitären Kapazitäten der Portpins und des angeschlossenen äußeren Netzwerks gemeinsam mit den Innenwiderständen der Ausgangsstufen keine dann wirksamen Tiefpässe bilden. Es sei jedoch verstanden, dass auch Frequenzen außerhalb des angegebenen Bereichs verwendet werden können, da maximal tolerierbare Einflüsse immer von den tatsächlichen Gegebenheiten abhängen.

Innerhalb des angestrebten Stimulus-Frequenzbereiches ist der obere Bereich, z.B. von 500 kHz bis 5 MHz, für viele Messaufgaben, besonders im Automobil, bevorzugt geeignet. Das induktive System ist dann sehr klein und kann, da die benötigten Induktivitäten nur wenige Mikrohenry betragen, auch in Form von planaren Spulen kompakt und kostengünstig auf einer Leiterplatte integriert werden. Wird das induktive Systems in Form von planaren Spulen realisiert, so ist eine Stimulus-Frequenz im oberen Bereich besonders bevorzugt, weil die Impedanzen im induktiven System andernfalls typischerweise zu klein werden, um einer präzisen Messung ohne hohen Aufwand zugänglich zu sein.

Bevorzugt ist vorgesehen, dass die Messinduktivität mit einem ersten Pol an einem Portpin der elektronischen Steuerungseinheit angeschlossen ist, und mit einem zweiten Pol mit einem Potential verbunden ist, welches zumindest annähernd der halben Versorgungsspannung der elektronischen Steuerungseinheit entspricht.

Unter einer zumindest annähernd halben Versorgungsspannung kann dabei insbesondere ein Wert verstanden, welcher eine Abweichung von ± 10 % oder ± 5 % von der halben Versorgungsspannung hat. Es kann auch exakt die halbe Versorgungsspannung verwendet werden. Eine Abweichung von diesem exakten Wert führt nicht zu einem Messfehler, sondern kann ggf. lediglich die erreichbare Auflösung verschlechtern.

Das Potential, welches zumindest annähernd der halben Versorgungsspannung der elektronischen Steuerungseinheit entspricht, kann beispielsweise mittels eines Spannungsteilers erzeugt werden.

Das Potential, welches zumindest annähernd der halben Versorgungsspannung der elektronischen Steuerungseinheit entspricht, kann auch mittels eines Glättungskondensators erzeugt werden, wobei der Glättungskondensator mit einem ersten Pol mit einem Bezugspotential oder mit der Versorgungsspannung verbunden ist, und wobei ein zweiter Pol des Glättungskondensators über einen Widerstand mit einem Portpin der elektronischen Steuerungseinheit verbunden ist, welcher mit einem gepulsten Signal, insbesondere mit einem Signal mit vorgebbarem Tastverhältnis, beaufschlagt wird.

Der Widerstand kann dabei insbesondere zum Erreichen einer kleinen Restwelligkeit ausgelegt sein, wobei er bevorzugt einen Widerstandswert von über 100 kQ hat.

Die eben beschriebenen Ausführungen beruhen auf der Erkenntnis, dass die Spannungen an den Portpins die durch die Versorgungsspannung gegebenen Grenzen typischerweise nur minimal überschreiten dürfen. Für die Sekundärwicklungen eines Messtransformators bedeutet das, dass sie vorzugsweise nicht einfach einseitig mit Bezugspotential oder VDD verbunden und mit dem anderen Anschluss an den Portpin angeschlossen werden, denn in einem solchen Fall würden typischerweise bereits kleine Amplituden aus dem Versorgungsspannungsbereich herausführen. Stattdessen wird bevorzugt das angegebene Potential von etwa der halben Versorgungsspannung verwendet, um maximale Amplituden zu ermöglichen.

Dies kann mit einem einfachen Spannungsteiler gelöst werden, was einer einfachen Ausführung entspricht. Es kann auch wie angegeben ein RC-Glied verwendet werden. Der Kondensator wird einseitig mit der Versorgungsspannung oder Bezugspotential verbunden, die andere Seite wird mit einem Anschluss einer Sekundärwicklung des Messtransformators verbunden. An diesem Knoten ist ebenfalls der Widerstand angeschlossen, dessen Wert typischerweise im Bereich von über 100 kΩ liegt. Die andere Seite des Widerstandes ist mit einem Portpin verbunden. Typischerweise wechselt dabei die Ausgangsstufe timergesteuert zwischen den Logikpegeln und ggf. auch dem hochohmigen Zustand einer Tristate- Ausgangsstufe, um die Kondensatorspannung ungefähr bei der halben Versorgungsspannung zu halten. Besonders vorteilhaft ist dabei, wenn Timer des Mikrokontrollers einen Pulsweitenmodulator bilden können, weil dann für die Korrektur von Parameteränderungen nur das Pulsweitenmodulation (PWM)-Verhältnis eingestellt werden muss. Eine Zentraleinheit wird dann nur wenig mit dieser Aufgabe belastet. Der Widerstandswert im RC-Glied soll bevorzugt hoch sein, damit die Spannung bei der halben Versorgungsspannung nur eine geringe Restwelligkeit aufweist. Aufgrund der Filterwirkung der Messschaltung kann die Auswirkung der Restwelligkeit minimiert werden, indem die Signalfrequenz, die von einem Analog-Digital-Wandler (ADC) gemessen werden soll, einen hinreichenden Abstand von der PWM-Frequenz hält.

Das RC-Glied bietet insbesondere die Möglichkeit, eine weitere Verbesserung der messtechnischen Eigenschaften der Schaltung zu erreichen. Die Restwelligkeit am Kondensator kann gezielt als sogenannter "Dither" (engl. "zittern") eingesetzt werden, um die Auflösung der Messung zu erhöhen. Dabei wird ein Hilfssignal geringer Amplitude (die Restwelligkeit) zu einem Nutzsignal addiert. Durch mehrfaches Abtasten des Summensignals kann dann die Auflösung bei der Messung des Nutzsignals gesteigert werden. Das Verfahren ist unter dem Namen "Dithering" bekannt. Es sei erwähnt, dass das Dithering auch anderweitig, also beispielsweise ohne RC-Glied vorgesehen werden kann.

Die Filterfunktion kann anstelle des einfachen RC-Gliedes auch durch andere passive Tiefpässe erfolgen.

Bevorzugt ist die elektronische Steuerungseinheit dazu konfiguriert, beim Einschalten zunächst den Glättungskondensator auf die zumindest annähernd halbe Versorgungsspannung aufzuladen, während Portpins, an welchen der Parallelschwingkreis angeschlossen ist, den gleichen Logikpegel aufweisen, und erst danach eine Anregung des Parallelschwingkreises zu beginnen.

Zur Vorteilhaftigkeit dieses Vorgehens sei folgendes ausgeführt.

Die Verwendung von Induktivitäten bewirkt sowohl an den Portpins, die den Stimulus erzeugen, als auch an den Portpins, die der Messung dienen, die Gefahr von Überspannungen, die einen Mikrokontroller zerstören können. Maßnahmen zum Schutz des Mikrokontrollers wie ein in Serie geschalteter Widerstand beziehen sich auf den eingeschwungenen Zustand. Beim Einschalten des Systems können jedoch Überspannungen auftreten, auch wenn die Schaltung so aufgebaut ist, dass im eingeschwungenen Zustand keine Gefahr besteht. Zur Vermeidung einer Beschädigung ist eine auf Schutz ausgelegte Einschaltprozedur vorteilhaft, wenn die Verwendung von Schutzbauelementen eigens für den Einschaltvorgang vermieden werden soll. Es handelt sich dabei um einen Ablauf, der von der Zentraleinheit der elektronischen Steuerungseinheit bzw. des Mikrokontrollers per Programm durchgeführt werden kann. Sobald der eingeschwungene Zustand erreicht wurde, sind typischerweise keine gesonderten Maßnahmen mehr notwendig und der Messbetrieb kann beginnen.

Die Einschaltprozedur beginnt bevorzugt mit der Messschaltung, währenddessen bleibt der Stimulus noch abgeschaltet. Alle vorhandenen RC-Glieder bzw. passiven Tiefpässe, die der Erzeugung einer Spannung von etwa der halben Versorgungsspannung dienen, werden vorzugsweise vorgeladen, damit sie ihren Zweck erfüllen können. Wird der Stimulus aktiviert, bevor ungefähr die halbe Versorgungsspannung an den entsprechenden Knoten erreicht wurde, so können die induzierten Spannungen zu einer Verletzung des zulässigen Spannungsbereichs führen. In diesem Zusammenhang wirkt es störend, dass der Widerstand der RC-Glieder wie oben beschrieben hoch sein muss, denn dadurch kann das Vorladen sehr lange dauern, was eine unerwünschte Verzögerung zwischen dem Einschalten der Versorgungsspannung und der Messbereitschaft des Sensorsystems verursacht. Dies kann vermieden werden, indem die Kapazitäten der RC-Glieder stattdessen durch die ebenfalls angeschlossenen Induktivitäten und die entsprechenden Portpins aufgeladen werden. Dazu kann es notwendig sein, Strombegrenzungswiderstände an diesen Portpins vorzusehen, wenn keine Ausgangsstufen bzw. Konfigurationen von Ausgangsstufen vorhandenen sind, mit denen eine Strombegrenzung im Mikrokontroller vorgenommen werden kann, etwa durch schaltbare integrierte Pull-up-Widerstände.

Solange das Vorladen der RC-Glieder läuft, sollen die beiden Anschlüsse der elektronischen Steuerungseinheit bzw. des Mikrokontrollers, die den Stimulus bereitstellen, den gleichen Logikpegel aufweisen, damit kein Strom durch die entsprechende Induktivität fließt. Die Induktivität ist für Gleichstrom sehr niederohmig und kommt einem Kurzschluss gleich, der diese Anschlüsse zerstören würde. Vorteilhaft ist auch der hochohmige Zustand von Tristate-Ausgängen. Wird schließlich der Stimulus gestartet, so soll er bevorzugt an beiden Anschlüssen fast gleichzeitig aktiviert werden, um den unvermeidlichen Kurzschluss beim ersten Pegelwechsel des ersten Anschlusses so kurz wie möglich zu halten. Das Programm ist bevorzugt so zu schreiben, dass die Verzögerung zwischen den Aktivierungszeitpunkten der Ausgänge deterministisch ist, indem andere Aktivitäten blockiert werden, z.B. kein Interrupt zugelassen wird.

Ein von der Messinduktivität erzeugtes Signal wird bevorzugt mit einem Analog-Digital-Wandler der elektronischen Steuerungseinheit erfasst, wobei unter Berücksichtigung von Aliasing dessen Kennwerte, insbesondere Amplitude, Phase, Realteil und/oder Imaginärteil bestimmt werden, vorzugsweise bei der Anregungsfrequenz.

Vorteilhaft ist vorgesehen, dass aus einem in der elektronischen Steuerungseinheit erfassten Signal eine Frequenzkomponente bei einer Auswertungsfrequenz ermittelt wird, wobei die Auswertungsfrequenz insbesondere die Anregungsfrequenz oder ein Alias der Anregungsfrequenz ist.

Zu derartigen Ausführungen seien die nachfolgenden Bemerkungen gegeben.

Wenn die gewählte Stimulus-Frequenz so hoch ist, dass die Nyquist-Frequenz des ADC auch bei maximal möglicher Abtastrate darunter liegt, so kann Unterabtastung gezielt eingesetzt werden. Dabei erscheint das Signal des Stimulus durch Aliasing bei einer Frequenz unterhalb der jeweiligen Nyquist-Frequenz am Ausgang des ADC; Aliasing ist hier also keine Störung oder ein Ausschlusskriterium, sondern erwünscht. Nachrichtentechnisch gesehen handelt es sich beim Stimulus um einen amplitudenmodulierten Träger, denn wenn sich die Messgröße ändert, kommt es zu einer Amplitudenmodulation (AM) des Stimulus mit der Messgröße. Daraus leiten sich die Breite der AM-Seitenbänder und die Forderung ab, dass die Abtastrate für eine korrekte Funktion des erfindungsgemäßen Systems bevorzugt mindestens vier Mal so hoch sein soll wie die Bandbreite in der Messgröße, damit sich die Bänder nicht durch Aliasing störend überlappen, denn das AM-Signal weist die doppelte Bandbreite des Signals der Messgröße auf. Da das Signal des Stimulus selbst sehr schmalbandig ist - der Spulenstrom ist durch die Ergänzung des induktiven Systems zum Schwingkreis typischerweise fast sinusförmig - und die Bänder bei niederfrequenten Messgrößen leicht schmal gegenüber der Nyquist-Bandbreite des Analog-Digital-Wandlers (ADC) gestaltet werden können, sind keine gesonderten Maßnahmen notwendig, um ein unerwünschtes Überlappen von Bändern durch Aliasing und damit eine Verfälschung des Signals zu verhindern.

Da die Messinduktivität oder allgemein die Induktivitäten, an denen die zu messenden Spannungen abgegriffen werden, typischerweise niederohmig sind, stellt Rauschen kein wesentliches Problem dar. Nur der geringe ohmsche Widerstand der Induktivitäten stellt eine Rauschquelle dar. Aus dem gleichen Grund müssen typischerweise breitbandige Störquellen in der Umgebung des Sensors sehr große Amplituden aufweisen, um die Messung wesentlich zu beeinflussen: der geringe ohmsche Widerstand wirkt für kapazitiv oder induktiv gekoppelte Störquellen fast wie ein Kurzschluss, weil fast die gesamte Störspannung an der Koppelimpedanz abfällt. Lediglich schmalbandige Störer erreichen bei den meisten Anwendungen Amplituden, die für die Messschaltung relevant sind. Daher ist eine ebenfalls schmalbandige Filterung der zu messenden Spannungen sinnvoll.

Eine solche Filterung erfolgt typischerweise digital, indem eine Reihe von Abtastwerten des ADC benutzt wird, um die Stimulus-Frequenz im Eingangs-Frequenzgemisch zu isolieren. Dazu kann eine Implementierung der DFT (Diskrete Fourier-Transformation) benutzt werden, deren Algorithmus von einer Zentraleinheit der elektronischen Steuerungseinheit bzw. des Mikrokontrollers ausgeführt wird. Besonders bevorzugt ist die Verwendung eines Goertzel-Filters bzw. Goertzel-Algorithmus, der numerisch besonders effizient Betrag und Phase einer einzelnen Spektrallinie der DFT liefern kann. Als Frequenz dieser Spektrallinie ist bevorzugt die Frequenz des Stimulus, also die Anregungsfrequenz, bzw. derjenigen Alias-Frequenz, die durch eine Unterabtastung der Anregungsfrequenz entsteht zu wählen.

Gemäß einer Ausführung ist die Messinduktivität galvanisch mit der ersten Induktivität gekoppelt. Gemäß einer weiteren Ausführung ist die Messinduktivität magnetisch mit der ersten Induktivität gekoppelt. Die Messinduktivität kann insbesondere mit der ersten Induktivität durch Ausbildung als Messtransformator gekoppelt sein. Derartige Ausführungen haben sich für typische Anwendungen als vorteilhaft erwiesen.

Die erste Induktivität, die Messinduktivität und/oder die Kapazität sind bevorzugt Bauteile mit einer jeweiligen Toleranz zwischen 1 % und 10 %, bevorzugt von 1 %, oder von weniger als 1 %. Die Toleranz gibt dabei typischerweise die bauartbedingte maximale Abweichung zu einem Sollwert vor. Entsprechend geringe Toleranzen erleichtern vorliegend die Konzeption der Vorrichtung insbesondere im Kontext einer Massenfertigung, da bei einer geringen Toleranz auch die maximale Abweichung der Resonanzfrequenz des Parallelschwingkreises entsprechend gering ist.

Gemäß einer bevorzugten Ausführung ist vorgesehen, dass
- der Parallelschwingkreis eine maximale Güte aufweist, welche durch Maximierung eines Werts von Vt * Vt / V0 erhalten wird,
- wobei Vt ein Verhältnis aus Spulenstrom und Zuleitungsstrom bei maximaler Abweichung der Kapazität und der ersten Induktivität von ihren jeweiligen Werten bei der Resonanzfrequenz des Parallelschwingkreises bezeichnet, und
- wobei V0 ein Verhältnis aus Spulenstrom und Zuleitungsstrom bei jeweiligen Werten von Kapazität und erster Induktivität bei der Resonanzfrequenz des Parallelschwingkreises bezeichnet.

Die maximale Güte kann insbesondere durch Verschalten eines Widerstands im Parallelschwingkreis begrenzt werden.

Die maximale Abweichung wird typischerweise durch die Toleranz, also die weiter oben bereits erwähnte maximale Abweichung zum Sollwert, des jeweiligen Bauteils vorgegeben.

Zur Güte und zur eben erwähnten vorteilhaften Ausführung werden nachfolgend einige Ausführungen gegeben.

Passive Bauelemente der Elektrotechnik, wie z.B. Spulen und Kondensatoren, werden üblicherweise mit Toleranzen ihrer Kennwerte angeboten, die typischerweise zwischen 1 % und 10 % liegen. Noch niedrigere Werte als 1 % führen meist zu sehr hohen Kosten für die Bauelemente. Toleranzen von mehr als 10 % machen es demgegenüber schwierig, Schaltungen überhaupt sinnvoll auszulegen. Wird ein Schwingkreis aus toleranzbehafteten Bauelementen mit den Kennwerten L und C (Kapazität) aufgebaut, so ergibt sich aus der Schwingungsformel für die Resonanzfrequenz ω₀ = 1/√(LC), dass die Toleranz der Resonanzfrequenz ω₀ dem geometrischen Mittel √(LC) der Toleranzen der Bauelemente entspricht. Die Toleranz der Resonanzfrequenz von Schwingkreisen, die mit den üblichen Bauelementen aufgebaut sind, bewegt sich daher ebenfalls im Bereich von 1 % bis 10 %. Wird ein Schwingkreis so ausgelegt, dass seine nominale Resonanzfrequenz mit der Frequenz des Stimulus, also der Anregungsfrequenz übereinstimmt, muss man davon ausgehen, dass die reale Resonanzfrequenz um ± 1 % bis ± 10 % abweicht.

Eine wichtige Eigenschaft von Schwingkreisen ist ihre Güte Q. Sie ist ein Maß für die Verluste, die durch den ohmschen Widerstand im Kreis auftreten und für das Abklingen einer freien Schwingung. Je höher die Güte, desto geringer die Verluste und desto langsamer das Abklingen.

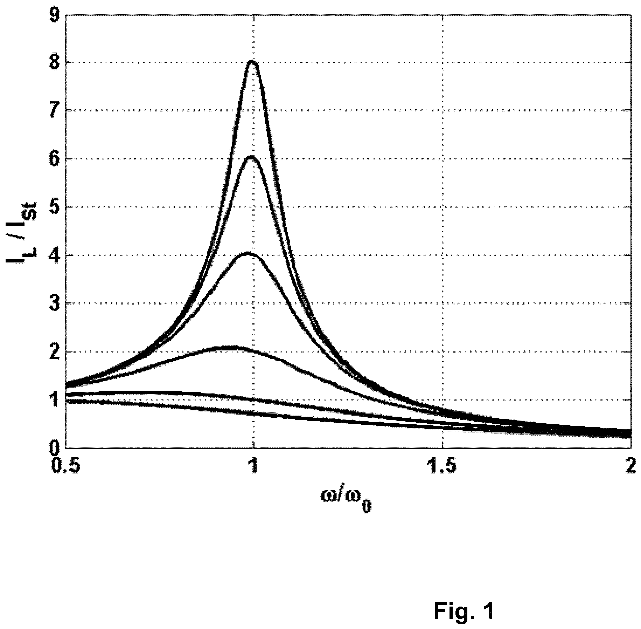

Figur 1 zeigt eine Kurvenschar, die die Auswirkung der Güte auf den Nutzen der Ergänzung des induktiven Systems zum Schwingkreis in Bezug auf den Stimulus, also die Anregung durch die Anregungsschaltung zeigt. Aufgetragen ist das Verhältnis des Stromes I_{L} durch die angeregte Induktivität zum Strom I_{St} des Stimulus. Ohne Ergänzung des induktiven Systems zum Schwingkreis wäre dieses Verhältnis immer gleich eins, weil es keinen weiteren Strompfad gibt. Da der Strom I_{L} dem Nutzstrom entspricht, weil durch ihn der magnetische Fluss erzeugt wird, während der Strom I_{St} dem Aufwand entspricht, bedeutet der aufgetragene Quotient einen Bewertungsfaktor für den Nutzen. Werte größer eins entsprechen einem Gewinn. Dieser Nutzen ist über die auf die Resonanzkreisfrequenz ω₀ normierte Kreisfrequenz ω aufgetragen. Der Scharparameter ist die Güte; der Wert bei ω₀ in jeder Kurve entspricht dabei dem Wert der Güte, d.h. die Kurven stellen die Güte Q mit den Werten 8; 6; 4; 2; 1; 1/√2 (von oben nach unten) dar.

Betrachtet man nun den Nutzen der Ergänzung des induktiven Systems zum Schwingkreis bei Frequenzen, die um beispielsweise ± 10 % von der Resonanzkreisfrequenz ω₀ abweichen, so stellt man fest, dass sich auch für diese Frequenzen ein hoher Nutzen einstellen kann, nicht nur bei der Nominalfrequenz. Je höher die Güte, desto höher ist jedoch das Verhältnis aus dem Nutzen bei der Resonanzfrequenz ω₀ und dem Nutzen bei einer Frequenz, die um ± 10 % abweicht. Grund ist der bekannte Zusammenhang, dass die Bandbreite der Resonanzüberhöhung bei zunehmender Güte immer schmaler wird. Für die Auslegung der hierin beschriebenen Vorrichtung besteht daher folgender Zielkonflikt: Einerseits sollte die Güte für einen möglichst hohen gütebedingten Nutzen möglichst hoch sein; andererseits bewirkt ein hohes Verhältnis des Nutzens in der Mitte (Resonanz) und an den Rändern des Toleranzbereichs eine Reduzierung der Nutzbarkeit, die sich folgendermaßen erklärt: Jedes übliche Messsystem, ob analog oder digital, hat eine maximale Eingangsamplitude, die typischerweise nicht überschritten werden darf. Im Rahmen dieses Maximums ist die relative Auflösung zum Eingangssignal proportional, weil der kleinste unterscheidbare Schritt des Eingangssignals im Eingangssignalbereich konstant ist. Wird nun der Eingangssignalbereich bei Resonanz voll ausgeschöpft, so ist der sich aus Figur 1 ergebende Nutzen auch voll nutzbar. An den Rändern des Toleranzbereiches jedoch ist der Nutzen reduziert um den Faktor, der sich aus dem Verhältnis des Nutzens in der Mitte (Resonanz) und an den Rändern des Toleranzbereichs ergibt.

Ziel ist eine optimale Auslegung des Sensorsystems im Rahmen des Entwurfs. Zunächst ist anzustreben, die Toleranz der Bauelementkennwerte L und C, bzw. ihr geometrisches Mittel √(LC), möglichst gering zu halten. Dabei ist hilfreich, dass in den letzten Jahren Kondensatoren mit Toleranzen von 1 % und besser verfügbar und billiger geworden sind. Die hauptsächliche Bedeutung für die Optimierung kommt aber der optimalen Wahl der Güte zu. Generell lassen sich hohe Gütewerte typischerweise nur in Kombination mit geringen Toleranzen des Terms √(LC) vorteilhaft nutzen. Das im Folgenden beschriebene Auslegungsverfahren basiert daher auf dem Gedanken, aufgrund der Verfügbarkeit geeigneter, eng tolerierter Kondensatoren und des Entwurfs eines induktiven Systems für die jeweilige Anwendung eine Toleranz für √(LC) festzulegen, aus der dann die optimale Güte berechnet werden kann.

Mit der Toleranz von √(LC) ist auch die Toleranz der Kreisfrequenz ω durch die Schwingungsformel festgelegt. Aus Figur 1 kann nun der Wert für I_{L}/I_{St} abgelesen werden für ω₀ (Resonanz) und ω_{T} (Kreisfrequenz gegeben durch die Toleranz; es kann die untere Frequenzgrenze gewählt werden, die obere oder beide). Dies kann auch numerisch geschehen; die Berechnung von Fig. 1 aus dem Zuleitungsstrom I_{St} und dem Spulenstrom I_{L} für einen Parallelschwingkreis gegebener Güte ist elementare Elektrotechnik und wird hier vorausgesetzt. Dadurch sind die Größen V0 = I_{L}(ω₀)/I_{St}(ω₀) und Vt = I_{L}(ω_{T})/I_{St}(ω_{T}) nun bekannt. Für eine Frequenz ω_{T} gilt dann: Der Bruchteil, mit dem der Eingangsspannungsbereich des Messsystems ausgeschöpft wird, ist durch den Term Vt/V0 gegeben. Bei dieser Frequenz ist der Nutzen, der durch die Ergänzung des induktiven Signals zum Schwingkreis erhalten wird, gleich Vt. Somit beträgt der Faktor, mit dem das ganze System von der Ergänzung des induktiven Signals zum Schwingkreis profitiert, das Produkt beider Terme: Vt²/V0. Durch elementare Umformungen der zugrundeliegenden Gleichungen kann dieser Faktor berechnet werden als Funktion von ω₀, ω_{T} und Q. Die Optimierung eines Systems besteht dann darin, Vt²/V0 zu maximieren, wodurch sich ein Ergebnis für Q in Abhängigkeit von ω₀ und ω_{T} ergibt. Durch weitere elementare mathematische Umformungen lässt sich auch Q in Abhängigkeit von ω₀ und ω_{T} auftragen. Aus einer solchen Darstellung lässt sich Q direkt ablesen, man spart sich so das wiederholte Einsetzen von Werten für Q in die Berechnung zur Maximumsuche. In beiden Fällen sind die Ergebnisse für Q stets maximale Werte, d.h. für ein entsprechend ausgelegtes System mit ω₀ und ω_{T} soll Q die berechneten Werte nie überschreiten, weil sonst der zugrunde gelegte Eingangssignalbereich des Messsystems verletzt wird. Bei einer Unterschreitung des berechneten Wertes von Q tritt keine Verletzung auf; der Eingangssignalbereich des Messsystems wird lediglich nicht ausgeschöpft. Dies ist wichtig für die Auslegung des Schwingkreises, da eine zu hohe Güte Q stets in einfacher Weise durch Hinzufügen eines ohmschen Widerstandes herabgesetzt werden kann; es bereitet jedoch u.U. große Schwierigkeiten, eine niedrige durch die Eigenschaften des induktiven Systems gegebene Güte Q konstruktiv zu erhöhen. Ursache ist der parasitäre Charakter des Verlustwiderstandes in induktiven Bauelementen, der insbesondere in Sensorinduktivitäten oft hoch ist, weil ihre Windungen ausgedehnt und die magnetischen Kreise offen sind.

Es ergibt sich insgesamt folgende vorteilhafte Vorgehensweise bzw. folgendes Verfahren, zusammengefasst aus den obenstehenden Erläuterungen:
1. Auslegung des induktiven Systems (weitgehend außerhalb des Themas dieser Anmeldung)
2. Festlegung der Arbeitsfrequenz des induktiven Systems (weitgehend außerhalb des Themas dieser Anmeldung, da von der Auslegung bestimmt)
3. Auswahl eines Kondensators mit möglichst geringer Toleranz (dies kann insbesondere nach kommerziellen Kriterien erfolgen)
4. Berechnung des geometrischen Mittels der Toleranz der Bauelementwerte L und C
5. Bestimmung der Frequenz ω_{T} aus (4.)
6. Wiederholte Berechnung und Maximierung von Vt²/V0; Ergebnis ist die maximal zulässige Güte Q mit den gewählten Parametern
7. Ist die Güte des Schwingkreises aus L, C und seinem konstruktiv bedingten Verlustwiderstand kleiner als die maximal zulässige Güte Q? Wenn ja, fertig.
8. Wenn nein, Einfügen eines Widerstandes in den Schwingkreis, der die Güte auf den maximal zulässigen Wert herabsetzt.

Es sei verstanden, dass die eben beschriebenen Verfahrensschritte als Ganzes oder in beliebiger Unterkombination einen eigenständigen Erfindungsaspekt darstellen können.

Aus diesen Ausführungen leitet sich insbesondere die oben beschriebene Vorgehensweise bei der Bestimmung der Güte ab.

Die Messgröße kann beispielsweise durch Verändern einer Position eines magnetischen Kerns in der Messinduktivität abgefühlt werden. Dies kann den Wert der Induktivität der Messinduktivität ändern.

Die Messgröße kann auch durch Verändern eines Abstands zwischen Messinduktivität und erster Induktivität abgefühlt werden. Dies entspricht typischerweise einer Ausführung als Messtransformator, wobei die magnetische Kopplung verändert wird.

Außerdem kann die Messgröße beispielsweise durch Verändern einer Position eines magnetischen und leitfähigen, eines unmagnetischen und leitfähigen, oder eines magnetischen und nicht leitfähigen Elements benachbart zu Messinduktivität und erster Induktivität abgefühlt werden. Dies erlaubt eine Anpassung an unterschiedliche Aufgaben und Gegebenheiten. Das Element kann beispielsweise zwischen oder auch neben erster Induktivität und Messinduktivität angeordnet sein. Durch das Verändern seiner Position wird die Kopplung zwischen erster Induktivität und Messinduktivität verändert.

Ein magnetisches und leitfähiges Element kann beispielsweise aus Stahl sein. Ein unmagnetisches und leitfähiges Element kann beispielsweise aus Aluminium sein. Ein magnetisches und nicht leitfähiges Element kann beispielsweise aus Ferrit sein.

Die Messinduktivität kann insbesondere dazu ausgebildet sein, eine Messgröße in Form einer Position, einer Länge, eines Winkels, einer Kraft, eines Drucks und/oder eines Drehmoments abzufühlen. Dies entspricht typischen Einsatzszenarien.

Die elektronische Steuerungseinheit ist vorzugsweise dazu ausgebildet, einen oder mehrere der folgenden Kennwerte über der Messinduktivität zu messen:
- Selbstinduktivität bzw. Induktivität,
- Verlustwiderstand,
- komplexe Impedanz,
- Verlustwinkel,
- Gegeninduktivität zur ersten Induktivität.

Aus solchen Kennwerten kann typischerweise auf die Messgröße geschlossen werden.

Gemäß einer Weiterbildung ist vorgesehen, dass die Vorrichtung zwei, drei oder mehr als drei Messinduktivitäten aufweist. Diese können beispielsweise einzeln oder auch zusammen bewegbar ausgebildet sein. Sie können insbesondere von der gleichen Messgröße beeinflusst werden, so dass eine Kompensation von Störgrößen, insbesondere der Temperatur, möglich ist.

Insbesondere kann die Vorrichtung eine erste Messinduktivität und eine zweite Messinduktivität aufweisen, wobei die erste Messinduktivität an einem ersten Längsende der ersten Induktivität angeordnet ist und die zweite Messinduktivität an einem zweiten Längsende der ersten Induktivität angeordnet ist. Eine solche Ausführung hat sich für typische Anwendungen als vorteilhaft erwiesen.

Die erfindungsgemäße Vorrichtung kann beispielsweise einen Oszillator, einen optionalen Verstärker, ein induktives System, einen Schwingkreiskondensator, einen optionalen Messverstärker und ein Messsystem, insbesondere die Messvorrichtung aufweisen. Der Verstärker verstärkt das Signal des Oszillators, er kann insbesondere entfallen, wenn der Ausgang des Oszillators bereits ein hinreichend starkes Signal bereitstellt. Dieses Signal oder das des Verstärkers bilden den Stimulus für das induktive System, welches durch den Kondensator zum Schwingkreis ergänzt wird. Insbesondere können die weiter oben bereits erwähnte erste Induktivität und die ebenfalls bereits erwähnte Messinduktivität als induktives System angesehen werden. Falls das Ausgangssignal zu schwach für das Messsystem ist, kann ein zusätzlicher Messverstärker verwendet werden, andernfalls kann insbesondere das Messsystem direkt mit dem induktiven System verbunden werden, beispielsweise indem eine elektrische Größe oder mehrere elektrische Größen am induktiven System abgegriffen wird oder werden. Das Messsystem kann beispielsweise als in analoger oder digitaler Technik und ggf. Software implementierter Lock-in-Verstärker (bzw. phasenempfindlicher Gleichrichter, Synchrondemodulator oder Trägerfrequenzverstärker) ausgeführt sein und kann unter Zuhilfenahme des Oszillatorsignals als Referenzsignal einen oder mehrere Kennwerte des induktiven Systems ermitteln.

Bevorzugt ist die Anregungsfrequenz einstellbar. Insbesondere kann sie softwaremäßig einstellbar sein. Dies erlaubt eine Modulation der Anregungsfrequenz bzw. des Stimulus. Alternativ kann die Anregungsfrequenz auch fest vorgegeben sein.

Die elektronische Steuerungseinheit kann für die hierin beschriebene Messung insbesondere als Lock-In-Verstärker ausgebildet bzw. konfiguriert sein. Dieser kann auch als phasenempfindlicher Gleichrichter, Synchrondemodulator oder Trägerfrequenzverstärker bezeichnet werden und hat sich für die hier relevante Anwendung als vorteilhaft erwiesen.

Durch die beschriebene Auslegung eines induktiven Systems und einer Kombination aus den hierin beschriebenen Komponenten wird erreicht, dass die Überhöhung der für die Messung maßgeblichen Größen, wie sie für Resonanz charakteristisch ist, in Verbindung mit einem Signalverarbeitungsweg, wie er vom Lock-in-Verstärker bekannt ist, verbunden werden kann. Dadurch wird der Strombedarf eines induktiven Sensorsystems verringert und/oder seine Messauflösung wird erhöht. Für die praktische Auslegung von induktiven Sensorsystemen mit offenen magnetischen Kreisen können für Vt²/V0 vorteilhaft typische Werte im Bereich von 3 bis 8 verwendet bzw. erwartet werden.

Weitere Merkmale und Vorteile wird der Fachmann aus den nachfolgend mit Bezug auf die beigefügte Zeichnung beschriebenen Ausführungsbeispielen entnehmen.
Figur 1 zeigt beispielhafte Verläufe einer Güte, auf welche bereits weiter oben in dieser Anmeldung eingegangen wurde.
Figur 2 zeigt eine Vorrichtung gemäß einem ersten Ausführungsbeispiel der Erfindung.
Figur 3 zeigt eine Vorrichtung gemäß einem zweiten Ausführungsbeispiel der Erfindung.

Figur 1 wurde bereits weiter oben im Text erwähnt und erläutert.

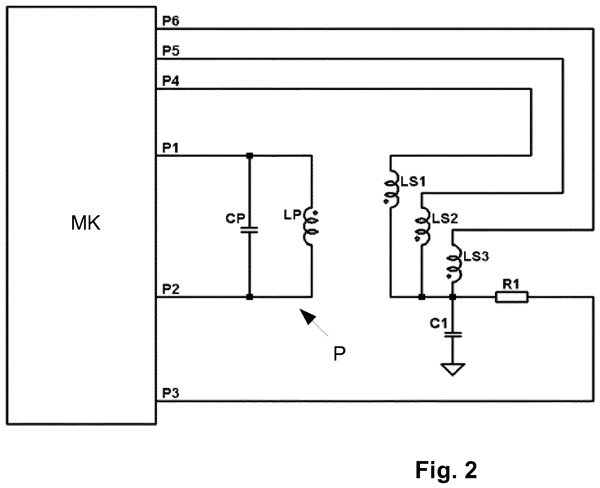

Figur 2 zeigt eine Vorrichtung gemäß einem ersten Ausführungsbeispiel der Erfindung mit einer elektronischen Steuerungseinheit in Form eines Mikrokontrollers MK. Ein induktives System ist dabei als Messtransformator aus erster Induktivtät LP sowie drei Messinduktivitäten, nämlich einer ersten Messinduktivität LS1, einer zweiten Messinduktivität LS2 und einer dritten Messinduktivität LS3 ausgeführt. Ein Stimulus wird durch Portpins P1 und P2 des Mikrokontrollers MK bereitgestellt, die von internen Timern mit einer vorgesehenen Anregungsfrequenz bzw. Stimulus-Frequenz angesteuert werden.

Parallel zur ersten Induktiviät LP ist eine Kapazität CP geschaltet, wodurch sich ein Parallelschwingkreis P ergibt. Die Schwingungen des Schwingkreises P werden fortlaufend durch alternierende Spannungen an P1 und P2 aufrechterhalten, so dass sich eine Schwingung konstanter Amplitude ergibt.

Der Strom durch die erste Induktivität LP bewirkt einen magnetischen Fluss, der auch die Messinduktivitäten LS1, LS2, LS3 erfasst. Die magnetische Kopplung wird durch den Pfeil symbolisiert. Der Prozentsatz des magnetischen Flusses der ersten Induktivität LP, der auch durch die Messinduktivitäten LS1, LS2 und LS3 geht, hängt dabei von der Messgröße ab. Im vorliegenden Ausführungsbeispiel kann sich der Abstand von erster Induktivität LP und den Messinduktivitäten LS1, LS2 und LS3 ändern, um diesen zu messen.

Es könnte sich aber alternativ auch beispielsweise ein weichmagnetischer Kern oder ein elektrisch leitfähiger Körper zwischen der ersten Induktivität LP und den Messinduktivitäten LS1, LS2 und LS3 befinden, dessen Bewegung gemessen wird. Jegliche Anordnung, die eine Parameteränderung des induktiven Systems bewirkt, ist grundsätzlich möglich.

Grundsätzlich induziert der magnetische Fluss in den Messinduktivitäten LS1, LS2 und LS3 Spannungen, die Portpins P4, P5, P6 des Mikrokontrollers MK zugeleitet werden. Ein Vorteil der Verwendung von drei Induktivtäten LS1, LS2 und LS3 anstelle einer einzigen ist die Möglichkeit, mehr Daten zur Messung der Messgröße zu gewinnen. Werte der Messinduktivitäten LS1, LS2 und LS3 hängen daher in unterschiedlicher Weise von der Messgröße ab, so dass etwaige Messfehler an einer der Messinduktivitäten LS1, LS2, LS3 durch rechnerische Berücksichtigung der Messwerte an allen Messinduktivtäten LS1, LS2 und LS3 korrigiert werden können. Insbesondere kann dabei eine Kompensation der typischerweise wichtigsten Störgröße, nämlich der Temperatur, vorgenommen werden. Alternativ können jedoch auch mehrere Messgrößen mit einem System erfasst werden.

Die Spannungen an den Portpins P4, P5, P6 werden wechselweise über einen integrierten Multiplexer einem Analog-Digital-Konverter (ADC) im Mikrokontroller MK zugeleitet. Der ADC erfasst jede dieser Spannungen mehrfach. Aus der Mehrzahl an Abtastwerten, die durch den ADC für jede Spannung ermittelt werden, wird die Amplitude und Phase bei der Stimulus-Frequenz ermittelt. Weitere Schritte digitaler Signalverarbeitung und Software können vorgenommen werden, um aus den Amplituden- und Phasenwerten schließlich den Messwert für die Messgröße zu bestimmen.

Wie gezeigt sind die Messinduktivitäten LS1, LS2, LS3 an ihren jeweiligen Polen, welche den mit den Portpins P4, P5, P6 verbundenen Polen gegenüberliegen, mit einem gemeinsamen Potential verbunden, welches durch einen Glättungskondensator C1 definiert wird. Der Glättungskondensator C1 ist an seinem Pol, welcher dieses Potential definiert, über einen Widerstand R1 mit einem Portpin P3 des Mikrokontrollers MK verbunden. An diesem Portpin P3 legt der Mikrokontroller MK im Betrieb ein pulsweitenmoduliertes Signal an, um im Mittel ein bestimmtes Potential an dem Glättungskondensator C1 aufrechtzuerhalten. Dieses Potential entspricht in etwa der halben Versorgungsspannung des Mikrokontrollers MK.

Es sei explizit darauf hingewiesen, dass außer den bereits erwähnten Komponenten Mikrokontroller MK, erste Induktivität LP, Messinduktivitäten LS1, LS2, LS3, Kapazität CP, Glättungskondensator C1 und Widerstand R1 keine weiteren Komponenten in der Vorrichtung nach dem gezeigten Ausführungsbeispiel vorhanden sind. Insbesondere sind alle passiven Bauteile direkt an dem Mikrokontroller MK angeschlossen. Auf das Vorsehen zusätzlicher aktiver Komponenten wie Verstärker wird also verzichtet, was die Kosten minimiert.

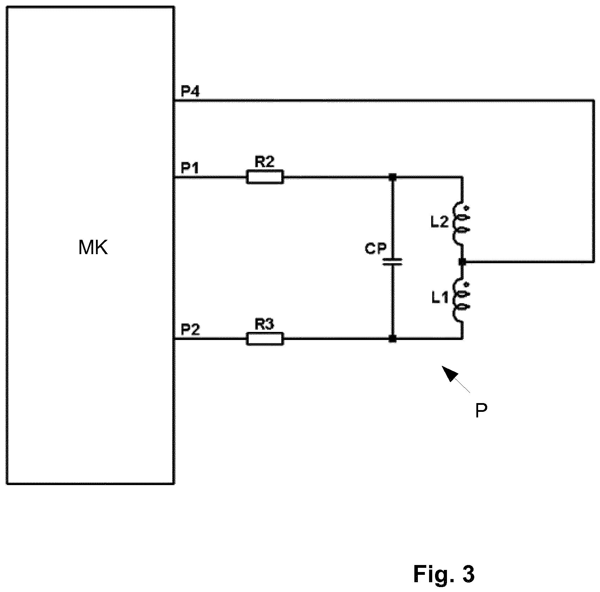

Figur 3 zeigt ein eine Vorrichtung gemäß einem zweiten Ausführungsbeispiel der Erfindung. Auch dabei ist ein Mikrokontroller MK vorgesehen. Die Unterschiede in der Beschaltung im Vergleich zur Vorrichtung gemäß dem ersten Ausführungsbeispiel werden nachfolgend erläutert.

Bei der Vorrichtung gemäß dem zweien Ausführungsbeispiel sind alle Induktivitäten galvanisch gekoppelt. Ein Parallelschwingkreis P wird von einer ersten Induktivität L1, einer Messinduktivität L2 und einer Kapazität CP gebildet. Die Messinduktivität L2 ist auf die Messgröße empfindlich und verändert sich, während die erste Induktivität L1 einen konstanten Wert aufweist. In den Verbindungsleitungen zu den Portpins P1, P2 befinden sich Widerstände R2 und R3, die die Portpins P1, P2 vor zu hohen Strömen schützen. Zwischen der ersten Induktivität L1 und der Messinduktivität L2 wird eine Spannung abgegriffen, die mit der Stimulus-Frequenz schwingt und deren Amplitude und Phase von der Messgröße abhängt. Bezüglich weiterer Aspekte sei auf Figur 2 verwiesen.

## Patentansprüche

1. Vorrichtung zum Messen einer Messgröße, aufweisend
- eine erste Induktivität (LP, L1),
- eine Messinduktivität (LS1, LS2, LS3, L2), welche zum Abfühlen der Messgröße ausgebildet ist und welche mit der ersten Induktivität (LP, L1) gekoppelt ist,
- eine Kapazität (CP), welche mit der ersten Induktivität (LP, L1) zu einem Parallelschwingkreis (P) verschaltet ist, und
- eine elektronische Steuerungseinheit (MK),
- wobei die elektronische Steuerungseinheit (MK) direkt mit dem Parallelschwingkreis (P) verbunden ist und dazu konfiguriert ist, den Parallelschwingkreis (P) mit einer Anregungsfrequenz oszillierend anzuregen, welche aus einem Takt der elektronischen Steuerungseinheit abgeleitet ist, und
- wobei die elektronische Steuerungseinheit (MK) direkt mit der Messinduktivität (LS1, LS2, LS3, L2) verbunden ist und dazu konfiguriert ist, einen die Messgröße anzeigenden Wert an der Messinduktivität (LS1, LS2, LS3, L2) zu messen, **dadurch gekennzeichnet, dass**
- der Parallelschwingkreis (P) an einem ersten Portpin und an einem zweiten Portpin der elektronischen Steuerungseinheit (MK) angeschlossen ist, wobei der zweite Portpin mit einem zum ersten Portpin invertierten Takt versorgt wird.

2. Vorrichtung nach Anspruch 1,
**dadurch gekennzeichnet, dass**
- der Parallelschwingkreis (P)
- parallel zum ersten Portpin mit einer Anzahl weiterer erster Portpins verbunden ist, welche zum ersten Portpin synchron geschalten werden,
und/oder
- parallel zum zweiten Portpin mit einer Anzahl weiterer zweiter Portpins verbunden ist, welche zum zweiten Portpin synchron geschalten werden.

3. Vorrichtung nach einem der vorhergehenden Ansprüche,
**dadurch gekennzeichnet, dass**
- Portpins, an welchen der Parallelschwingkreis (P) angeschlossen ist, eine Push-Pull-Ausgangsstufe oder eine Tristate-Ausgangsstufe aufweisen.

4. Vorrichtung nach einem der vorhergehenden Ansprüche,
**dadurch gekennzeichnet, dass**
- die Anregungsfrequenz sich um maximal 25 %, bevorzugt maximal 20 %, besonders bevorzugt maximal 15 %, noch weiter bevorzugt maximal 10 % von einer Resonanzfrequenz des Parallelschwingkreises (P) unterscheidet.

5. Vorrichtung nach einem der vorhergehenden Ansprüche,
**dadurch gekennzeichnet, dass**
- die Messinduktivität (LS1, LS2, LS3, L2) mit einem ersten Pol an einem Portpin der elektronischen Steuerungseinheit (MK) angeschlossen ist, und mit einem zweiten Pol mit einem Potential verbunden ist, welches zumindest annähernd der halben Versorgungsspannung der elektronischen Steuerungseinheit (MK) entspricht.

6. Vorrichtung nach Anspruch 5,
**dadurch gekennzeichnet, dass**
- das Potential, welches zumindest annähernd der halben Versorgungsspannung der elektronischen Steuerungseinheit (MK) entspricht, mittels eines Spannungsteilers erzeugt wird.

7. Vorrichtung nach einem der Ansprüche 5 oder 6,
**dadurch gekennzeichnet, dass**
- das Potential, welches zumindest annähernd der halben Versorgungsspannung der elektronischen Steuerungseinheit (MK) entspricht, mittels eines Glättungskondensators (C1) erzeugt wird,
- wobei der Glättungskondensator (C1) mit einem ersten Pol mit einem Bezugspotential oder mit der Versorgungsspannung verbunden ist,
- und wobei ein zweiter Pol des Glättungskondensators (C1) über einen Widerstand (R1) mit einem Portpin der elektronischen Steuerungseinheit (MK) verbunden ist, welcher mit einem gepulsten Signal, insbesondere mit einem Signal mit vorgebbarem Tastverhältnis, beaufschlagt wird.

8. Vorrichtung nach Anspruch 7,
**dadurch gekennzeichnet, dass**
- die elektronische Steuerungseinheit (MK) dazu konfiguriert ist, beim Einschalten zunächst den Glättungskondensator auf die zumindest annähernd halbe Versorgungsspannung aufzuladen, während Portpins, an welchen der Parallelschwingkreis (P) angeschlossen ist, den gleichen Logikpegel aufweisen, und erst danach eine Anregung des Parallelschwingkreises (P) zu beginnen.

9. Vorrichtung nach einem der vorhergehenden Ansprüche,
**dadurch gekennzeichnet, dass**
- ein von der Messinduktivität (LS1, LS2, LS3, L2) erzeugtes Signal mit einem Analog-Digital-Wandler der elektronischen Steuerungseinheit (MK) erfasst und unter Berücksichtigung von Aliasing dessen Kennwerte, insbesondere Amplitude, Phase, Realteil und/oder Imaginärteil bestimmt werden, vorzugsweise bei der Anregungsfrequenz.

10. Vorrichtung nach einem der vorhergehenden Ansprüche,
**dadurch gekennzeichnet, dass**
- aus einem in der elektronischen Steuerungseinheit (MK) erfassten Signal eine Frequenzkomponente bei einer Auswertungsfrequenz ermittelt wird,
- wobei die Auswertungsfrequenz insbesondere die Anregungsfrequenz oder ein Alias der Anregungsfrequenz ist.

11. Vorrichtung nach einem der vorhergehenden Ansprüche,
**dadurch gekennzeichnet, dass**
- die Messinduktivität (LS1, LS2, LS3, L2) galvanisch oder magnetisch mit der ersten Induktivität (LP, L1) gekoppelt ist.

12. Vorrichtung nach einem der vorhergehenden Ansprüche,
**dadurch gekennzeichnet, dass**
- die erste Induktivität und die Kapazität jeweils eine vorgegebene Toleranz aufweisen und damit eine vom jeweiligen Nominalwert maximal zu erwartende Abweichung aufweisen,
- der Parallelschwingkreis (P) eine optimale Güte aufweist, welche durch Maximierung eines Werts von Vt ^{∗} Vt / V0 erhalten wird,
- wobei Vt ein Verhältnis aus Spulenstrom und Zuleitungsstrom bei der maximal zu erwartenden Abweichung der Kapazität (CP) und der ersten Induktivität (LP, L1) von ihren jeweiligen Nominalwerten bei der Resonanzfrequenz des Parallelschwingkreises (P) bezeichnet, und
- wobei V0 ein Verhältnis aus Spulenstrom und Zuleitungsstrom bei jeweiligen Werten von Kapazität (CP) und erster Induktivität (LP, L1) bei der tatsächlich gegebenen Resonanzfrequenz des Parallelschwingkreises (P) bezeichnet.

13. Vorrichtung nach einem der vorhergehenden Ansprüche,
**dadurch gekennzeichnet, dass** die Messgröße
- durch Verändern einer Position eines magnetischen Kerns in der Messinduktivität (LS1, LS2, LS3, L2),
- durch Verändern eines Abstands zwischen Messinduktivität (LS1, LS2, LS3, L2) und erster Induktivität (LP, L1), und/oder
- durch Verändern einer Position eines
- magnetischen und leitfähigen,
- unmagnetischen und leitfähigen, oder
- magnetischen und nicht leitfähigen
Elements benachbart zur Messinduktivität (LS1, LS2, LS3, L2) und zur ersten Induktivität (LP, L1) abgefühlt wird.

14. Vorrichtung nach einem der vorhergehenden Ansprüche,
**dadurch gekennzeichnet, dass**
- die Vorrichtung zwei, drei oder mehr als drei Messinduktivitäten (LS1, LS2, LS3, L2) aufweist.

## Claims

1. Apparatus for measuring a measured variable, having
- a first inductance (LP, L1),
- a measurement inductance (LS1, LS2, LS3, L2) that is set up to detect the measured variable and that is coupled to the first inductance (LP, L1),
- a capacitance (CP) that is interconnected with the first inductance (LP, L1) to form a parallel resonant circuit (P), and
- an electronic control unit (MK),
- wherein the electronic control unit (MK) is connected directly to the parallel resonant circuit (P) and is configured to excite the parallel resonant circuit (P) into oscillation at an excitation frequency that is derived from a clock of the electronic control unit, and
- wherein the electronic control unit (MK) is connected directly to the measurement inductance (LS1, LS2, LS3, L2) and is configured to measure a value revealing the measured variable using the measurement inductance (LS1, LS2, LS3, L2),
**characterized in that**
- the parallel resonant circuit (P) is connected to a first port pin and to a second port pin of the electronic control unit (MK), the second port pin being supplied with a clock that is inverted in relation to the first port pin.

2. Apparatus according to Claim 1,
**characterized in that**
- the parallel resonant circuit (P)
- is connected in parallel with the first port pin to a number of further first port pins that are connected to the first port pin in sync, and/or
- is connected in parallel with the second port pin to a number of further second port pins that are connected to the second port pin in sync.

3. Apparatus according to one of the preceding claims, **characterized in that**
- port pins to which the parallel resonant circuit (P) is connected have a push-pull output stage or a tristate output stage.

4. Apparatus according to one of the preceding claims, **characterized in that**
- the excitation frequency differs from a resonant frequency of the parallel resonant circuit (P) by no more than 25%, preferably no more than 20%, particularly preferably no more than 15%, even more preferably no more than 10%.

5. Apparatus according to one of the preceding claims, **characterized in that**
- the measurement inductance (LS1, LS2, LS3, L2) has a first pole connected to a port pin of the electronic control unit (MK) and has a second pole connected to a potential that corresponds to at least approximately half the supply voltage of the electronic control unit (MK).

6. Apparatus according to Claim 5,
**characterized in that**
- the potential that corresponds to at least approximately half the supply voltage of the electronic control unit (MK) is produced by means of a voltage divider.

7. Apparatus according to either of Claims 5 and 6, **characterized in that**
- the potential that corresponds to at least approximately half the supply voltage of the electronic control unit (MK) is produced by means of a smoothing capacitor (C1),
- wherein the smoothing capacitor (C1) has a first pole connected to a reference-ground potential or to the supply voltage,
- and wherein a second pole of the smoothing capacitor (C1) is connected via a resistor (R1) to a port pin of the electronic control unit (MK), which port pin has a pulsed signal, particularly a signal having a prescribed duty ratio, applied to it.

8. Apparatus according to Claim 7,
**characterized in that**
- the electronic control unit (MK) is configured to first of all, when it is switched on, charge the smoothing capacitor to at least approximately half the supply voltage, while port pins to which the parallel resonant circuit (P) is connected have the same logic level and begin excitation of the parallel resonant circuit (P) only afterwards.

9. Apparatus according to one of the preceding claims,
**characterized in that**
- a signal generated by the measurement inductance (LS1, LS2, LS3, L2) is captured with an analog-to-digital converter of the electronic control unit (MK), aliasing being taken into consideration when determining the characteristic values of said signal, particularly amplitude, phase, real part and/or imaginary part, preferably at the excitation frequency.

10. Apparatus according to one of the preceding claims, **characterized in that**
- a frequency component is ascertained at an evaluation frequency from a signal captured in the electronic control unit (MK),
- wherein the evaluation frequency is particularly the excitation frequency or an alias of the excitation frequency.

11. Apparatus according to one of the preceding claims, **characterized in that**
- the measurement inductance (LS1, LS2, LS3, L2) is DC or magnetically coupled to the first inductance (LP, L1).

12. Apparatus according to one of the preceding claims, **characterized in that**
- the first inductance and the capacitance each have a prescribed tolerance and thus a maximum expected deviation from the respective nominal value,
- the parallel resonant circuit (P) has a optimal Q factor obtained through maximisation of a value of Vt ^{∗} Vt / V0,
- where Vt denotes a ratio of coil current and supply line current given the maximum expected deviation of the capacitance (CP) and of the first inductance (LP, L1) from their respective nominal values at the resonant frequency of the parallel resonant circuit (P), and
- where V0 denotes a ratio of coil current and supply line current for respective values of capacitance (CP) and first inductance (LP, L1) at the actually provided resonant frequency of the parallel resonant circuit (P).

13. Apparatus according to one of the preceding claims,
**characterized in that** the measured variable is detected
- by altering a position of a magnetic core in the measurement inductance(LS1, LS2, LS3, L2),
- by altering a spacing between the measurement inductance (LS1, LS2, LS3, L2) and the first inductance (LP, L1), and/or
- by altering a position of
- a magnetic and conductive,
- a nonmagnetic and conductive, or
- a magnetic and nonconductive
element adjacent to the measurement inductance (LS1, LS2, LS3, L2) and the first inductance (LP, L1).

14. Apparatus according to one of the preceding claims, **characterized in that**
- the apparatus has two, three or more than three measurement inductances (LS1, LS2, LS3, L2).

## Revendications

1. Dispositif de mesure d'une grandeur de mesure, comportant
- une première inductance (LP, L1)
- une inductance de mesure (LS1, LS2, LS3, L2), laquelle est réalisée pour détecter la grandeur de mesure et laquelle est couplée à la première inductance (LP, L1),
- une capacité (CP), laquelle est branchée avec la première inductance (LP, L1) à un circuit oscillant parallèle (P), et
- une unité de commande électronique (MK),
- dans lequel l'unité de commande électronique (MK) est directement reliée au circuit oscillant parallèle (P) et est configurée de façon à exciter de manière oscillante le circuit oscillant parallèle (P) avec une fréquence d'excitation, laquelle est dérivée d'une horloge de l'unité de commande électronique, et
- dans lequel l'unité de commande électronique (MK) est directement reliée à l'inductance de mesure (LS1, LS2, LS3, L2) et est configurée de façon à mesurer sur l'inductance de mesure (LS1, LS2, LS3, L2) une valeur indiquant la grandeur de mesure,
- **caractérisé en ce que** le circuit oscillant parallèle (P) est raccordé à une première broche de port et à une deuxième broche de port de l'unité de commande électronique (MK), dans lequel la deuxième broche de port est alimentée avec une horloge inversée par rapport à la première broche de port.

2. Dispositif selon la revendication 1, **caractérisé en ce que** le circuit oscillant parallèle (P)
- est relié en parallèle de la première broche de port à un nombre de premières broches de port, lesquelles sont connectées de manière synchrone à la première broche de port, et/ou
- est relié en parallèle de la deuxième broche de port à un nombre de deuxièmes broches de port, lesquelles sont connectées de manière synchrone à la deuxième broche de port.

3. Dispositif selon l'une des revendications précédentes, **caractérisé en ce que** les broches de port auxquelles le circuit oscillant parallèle (P) est raccordé comportent un étage de sortie push-pull ou un étage de sortie à trois états.

4. Dispositif selon l'une des revendications précédentes, **caractérisé en ce que** la fréquence d'excitation diffère d'une fréquence de résonance du circuit oscillant parallèle (P) d'un maximum de 25 %, de préférence d'un maximum de 20 %, plus particulièrement d'un maximum de 15 %, tout particulièrement d'un maximum de 10 %.

5. Dispositif selon l'une des revendications précédentes, **caractérisé en ce que** l'inductance de mesure (LS1, LS2, LS3, L2) est raccordée par un premier pôle à une broche de port de l'unité de commande électronique (MK), et par un deuxième pôle à un potentiel correspondant au moins approximativement à la moitié de la tension d'alimentation de l'unité de commande électronique (MK).

6. Dispositif selon la revendication 5, **caractérisé en ce que** le potentiel correspondant au moins approximativement à la moitié de la tension d'alimentation de l'unité de commande électronique (MK) est produit au moyen d'un diviseur de tension.

7. Dispositif selon l'une des revendications 5 ou 6, **caractérisé en ce que**
- le potentiel correspondant au moins approximativement à la moitié de la tension d'alimentation de l'unité de commande électronique (MK) est produit au moyen d'un condensateur de lissage (C1),
- dans lequel le condensateur de lissage (C1) est relié par un premier pôle à un potentiel de référence ou à une tension d'alimentation,
- et dans lequel un deuxième pôle du condensateur de lissage (C1) est relié par le biais d'une résistance (R1) à une broche de port de l'unité de commande électronique (MK), laquelle est soumise à un signal pulsé, en particulier à un signal avec un rapport cyclique pré-définissable.

8. Dispositif selon la revendication 7, **caractérisé en ce que** l'unité de commande électronique (MK) est configurée de façon à charger d'abord le condensateur de lissage jusqu'à au moins approximativement la moitié de la tension d'alimentation lors de l'allumage, pendant que les broches de port auxquelles le circuit oscillant parallèle (P) est raccordé comportent le même niveau logique, et seulement ensuite à commencer une excitation du circuit oscillant parallèle (P).

9. Dispositif selon l'une des revendications précédentes, **caractérisé en ce qu'**un signal produit par l'inductance de mesure (LS1, LS2, LS3, L2) est saisi par un convertisseur analogique-numérique de l'unité de commande électronique (MK) et ses valeurs caractéristiques, en particulier l'amplitude, la phase, la partie réelle et/ou la partie imaginaire, sont déterminées compte tenu du crénelage, de préférence à la fréquence d'excitation.

10. Dispositif selon l'une des revendications précédentes, **caractérisé en ce que**
- à partir d'un signal saisi dans l'unité de commande électronique (MK) une composante de fréquence est déterminée à une fréquence d'évaluation,
- dans lequel la fréquence d'évaluation est en particulier la fréquence d'excitation ou un repliement de la fréquence d'excitation.

11. Dispositif selon l'une des revendications précédentes, **caractérisé en ce que** l'inductance de mesure (LS1, LS2, LS3, L2) est couplée galvaniquement ou magnétiquement à la première inductance (LP, L1).

12. Dispositif selon l'une des revendications précédentes, **caractérisé en ce que**
- la première inductance et la capacité possèdent respectivement une tolérance prédéfinie et possèdent ainsi un écart maximal escompté par rapport à la valeur nominale respective,
- le circuit oscillant parallèle (P) possède une qualité optimale, laquelle est obtenue en maximisant une valeur de Vt ^{∗} Vt/V0,
- dans lequel Vt désigne un rapport du courant de bobine et du courant de ligne d'entrée à l'écart escompté par rapport à leurs valeurs nominales respectives de la capacité (CP) et de la première inductance (LP, L1) à la fréquence de résonance du circuit oscillant parallèle (P), et
- dans lequel V0 désigne un rapport du courant de bobine et du courant de ligne d'entrée aux valeurs respectives de la capacité (CP) et de la première inductance (LP, L1) à la fréquence de résonance réelle du circuit oscillant parallèle (P).

13. Dispositif selon l'une des revendications précédentes, **caractérisé en ce que** la grandeur de mesure peut être détectée
- par variation d'une position d'un noyau magnétique dans l'inductance de mesure (LS1, LS2, LS3, L2),
- par variation d'une distance entre l'inductance de mesure (LS1, LS2, LS3, L2) et la première inductance (LP, L1), et/ou
- par variation d'une position d'un élément
∘ magnétique et conducteur,
∘ non-magnétique et conducteur, ou
∘ magnétique et non-conducteur contigu à l'inductance de mesure (LS1, LS2, LS3, L2) et à la première inductance (LP, L1).

14. Dispositif selon l'une des revendications précédentes, **caractérisé en ce que** le dispositif comporte deux, trois ou plus de trois inductances de mesure (LS1, LS2, LS3, L2).
